# EUROPÄISCHE PATENTSCHRIFT

(11) **EP 2 239 692 B1**
(45) Veröffentlichungstag und Bekanntmachung des Hinweises auf die Patenterteilung: **19.06.2013**
(21) Anmeldenummer: 10159352.3
(22) Anmeldetag: 08.04.2010
(51) Int. Cl.: G06K 19/077

(54) **Chipkarte und Verfahren zu deren Herstellung**
Chip card and method for its manufacture
Carte à puce et procédé destiné à sa fabrication

(30) Priorität: 11.04.2009 DE 102009017290
(43) Veröffentlichungstag der Anmeldung: 13.10.2010
(73) Patentinhaber: Cardag Deutschland GmbH, 99848 Wutha-Farnroda (DE)
(72) Erfinder: Schmidt, Frank, 99891 Fischbach (DE)
(74) Vertreter: Liedtke, Markus

(56) Entgegenhaltungen:
- EP-A1- 1 684 216
- WO-A2-97/34247
- FR-A1- 2 753 819
- FR-A1- 2 788 646

## Beschreibung

Die Erfindung betrifft eine Chipkarte mit einem Kartenkörper, einem Chipmodul und einem Bauelement zur berührungslosen Datenübertragung und ein Verfahren zur Herstellung einer derartigen Chipkarte.

Unter einer Chipkarte wird hier eine kartenförmige Einheit mit einem eingebauten integrierten Schaltkreis, im folgenden auch als Chip bezeichnet, und wenigstens einer Schnittstelle zum kontaktbehafteten oder kontaktlosen Datenaustausch verstanden. Dies schließt beispielsweise Geld- und Kreditkarten ebenso ein wie maschinenlesbare Ausweisdokumente mit einem Chip.

Eine derartige Chipkarte und ein Verfahren zur Herstellung einer Chipkarte sind beispielsweise aus der EP 1 021 792 B1 bekannt. Die Chipkarte weist eine Antenne auf, an deren Enden Anschlussflächen vorgesehen sind. Die Antenne wird auf einer Trägerfolie mit mindestens zwei Spiralwindungen und einer Isolierungsbrücke realisiert, wobei die Isolierungsbrücke die Spiralwindungen überkreuzt, so dass die Anschlussflächen auf der gleichen Seite der Spiralwindungen liegen. Die Trägerfolie wird zur Bildung eines Kartenkörpers mit Plastikfolien zusammengefügt. Anschließend werden eine Ausnehmung und Anschlussschächte in eine obere Seite des Kartenkörpers gearbeitet. Dann wird ein elektronisches Modul in der Ausnehmung befestigt. Dabei weist das Modul an seiner zum Inneren der Ausnehmung gerichteten Unterseite leitende Bereiche auf, die mit den Anschlussflächen der Antenne mittels eines in die Anschlussschächte eingebrachten leitenden Verbindungselementes elektrisch verbunden sind. Als leitendes Verbindungselement wird beispielsweise eine Lötpaste mit niedriger Schmelztemperatur vorgeschlagen.

Die DE 102 57 111 B4 offenbart ebenfalls eine Chipkarte und ein Verfahren zur Herstellung einer Chipkarte. Die Chipkarte umfasst einen Kartenkörper, mindestens eine darin angeordnete Ausnehmung zur Aufnahme mindestens eines Chipmoduls und einen in den Kartenkörper eingebetteten leitfähigen Strukturkörper, insbesondere eine Antenne. Dabei sind bei eingebautem Chipmodul Modulanschlüsse des Chipmoduls und Körperkontaktanschlüsse des Strukturkörpers mittels Klebstoffteilen aus leitfähigem Material verbunden. Dazu werden vor dem Einbau des Chipmoduls Klebstoffteile auf die Körperkontaktanschlüsse und/oder die Modulanschlüsse innerhalb von Aussparungen des Kartenkörpers punktweise aufgetragen.

Bei diesen Chipkarten wird ein elektrischer Kontakt zwischen dem Chipmodul und einem weiteren Bauelement, insbesondere einer Antenne, durch ein Leitmedium wie eine Lötpaste oder einen leitfähigen Klebstoff hergestellt. Biegebeanspruchungen der Chipkarte können dabei eine Kontaktbeeinträchtigung oder Kontaktunterbrechung hervorrufen.

Ferner ist in DE 195 00 925 C2 ein Verfahren zur Herstellung einer kontaktlosen Chipkarte beschrieben, mit dem eine Antenne in den Kartenkörper so eingebaut wird, dass vor dem Einbau des teueren Chips in den Kartenkörper derselbe mit seiner im Kartenkörper-Herstellungsprozess ausgebildeten Oberfläche nach Ausschusskriterien beurteilbar ist. In den Kartenkörper wird hierbei ein separates Übertragungsmodul, welches eine Antenne aufweist, eingebaut. Das Übertragungsmodul weist Anschlußflächen zur elektrischen Ankopplung an das Chipmodul auf. Auf dem Chipmodul sind optional zusätzlich Kontaktflächen für eine kontaktbehaftete Datenübertragung vorgesehen. Das Chipmodul weist in einer Ausführungsform einen nicht leitenden Substratfilm auf, auf dem der Chip und die metallischen Anschlussflächen angeordnet sind, wobei der Chip über Bonddrähte mit den Anschlussflächen verbunden ist. Auf der einen Seite des Substratfilms sind der Chip und die metallischen Anschlussflächen zur Kontaktierung mit der Antenne angeordnet und auf der anderen Seite die Kontaktflächen für einen kontaktbehafteten Datenaustausch der Chipkarte. Im Substratfilm sind Zugangsöffnungen zu den Kontaktflächen ausgespart.

EP 1 684 216 A1 offenbart einen tragbaren Datenträger mit einem Datenträgerkörper, der wenigstens eine elektrische Komponente aufweist, und mit einem elektronischen Modul. Das elektronische Modul ist teilweise in den Datenträgerkörper eingebettet und weist auf einer Vorderseite, die nicht in den Datenträgerkörper eingebettet ist, wenigstens eine elektrisch leitfähige Struktur auf, über die das elektronische Modul mit der elektrischen Komponente des Datenträgerkörpers verbunden ist.

FR 2 753 819 A1 offenbart eine Chipkarte, die zwei Verbindungsmodi bietet. In den Kartenkörper der Chipkarte ist eine elektrische Verbindung für ein kontaktloses Kopplungselement zu einem einen integrierten Schaltkreis enthaltenden Modul eingebettet.

FR 2788646 A1, das als nächstliegender Stand der Technik betrachtet wird, offenbart eine Chipkarte mit einer offenen Schleifenantenne, deren Enden mit zwei Kontaktflächen verbunden sind.

Der Erfindung liegt die Aufgabe zu Grunde, eine verbesserte Chipkarte mit Schnittstellen zum kontaktbehafteten und kontaktlosen Datenaustausch anzugeben. Ferner liegt der Erfindung die Aufgabe zu Grunde, ein verbessertes Verfahren zur Herstellung einer derartigen Chipkarte anzugeben.

Die Aufgabe wird erfindungsgemäß hinsichtlich der Chipkarte durch die in Anspruch 1 angegebenen Merkmale und hinsichtlich des Verfahrens durch die in Anspruch 3 angegebenen Merkmale gelöst.

Vorteilhafte Ausgestaltungen der Erfindung sind Gegenstand der Unteransprüche.

Die erfindungsgemäße Chipkarte weist einen Kartenkörper, ein Chipmodul und ein Bauelement zur berührungslosen Datenübertragung auf. Das Chipmodul ist in einer Ausnehmung in dem Kartenkörper befestigt und weist einen Modulträger mit Kontaktflächen zur elektrischen Kontaktierung und einen auf dem Modulträger angeordneten Chip auf. Das Bauelement zur berührungslosen Datenübertragung ist in dem Kartenkörper angeordnet und weist zwei Kontaktenden auf. Dabei ist ein erstes Kontaktende einer ersten Kontaktfläche des Chipmoduls zugeordnet und mit dieser mittels eines Leitmediums elektrisch leitend verbunden und das zweite Kontaktende ist einer zweiten Kontaktfläche des Chipmoduls zugeordnet und mit dieser mittels des Leitmediums elektrisch leitend verbunden. Die erste Kontaktfläche und die zweite Kontaktfläche sind auf einer Oberseite des Modulträgers angeordnet, so dass sie Oberflächenbereiche der Chipkarte bilden. Der Modulträger weist im Bereich der ersten Kontaktfläche einen ersten Durchbruch für das Leitmedium und im Bereich der zweiten Kontaktfläche einen zweiten Durchbruch für das Leitmedium auf.

Im Unterschied zum aus der EP 1 021 792 B1 und der DE 102 57 111 B4 bekannten Stand der Technik sind dabei die erste und zweite Kontaktfläche, d.h. diejenigen Kontaktflächen des Chipmoduls, die direkt mit den Kontaktenden des Bauelementes zur berührungslosen Datenübertragung elektrisch leitend verbunden sind, auf der Oberseite des Modulträgers angeordnet statt auf dessen Unterseite.

Dies ermöglicht einerseits die Anordnung dieser Kontaktflächen und weiterer Kontaktflächen des Chipmoduls auf derselben Seite (Oberseite) des Chipmoduls und somit eine vorteilhafte, geometrisch einfache Anordnung aller Kontaktflächen des Chipmoduls in einem gemeinsamen Kontaktfeld auf der Oberseite des Chipmoduls. Insbesondere entfällt der Aufwand, beide Seiten des Modulträgers mit Kontaktflächen zu versehen.

Die in DE 195 00 925 C2 beschriebene Anordnung erfordert eine kostenaufwendige zweiseitige Leiterplatte, währen die erfindungsgemäße Anordnung nur einen einseitig kontaktierten Modulträger benötigt.

Ferner ermöglicht die Anordnung der Kontaktflächen eine direkte lokale Energiezufuhr zu der ersten und der zweiten Kontaktfläche nach dem Einsetzen des Chipmoduls, um in dem unten näher beschriebenen Verfahren zur Herstellung der Chipkarte die erste und die zweite Kontaktfläche mit dem jeweils zugeordneten Kontaktende des Bauelementes zur berührungslosen Datenübertragung zu verbinden. Dabei müssen keine dazwischen liegende Isolierschichten überwunden werden, sodass eine definierte lokale Wärmezufuhr ermöglicht wird, die eine Erwärmung außerhalb der Verbindungsstelle vermeidet.

Die Durchbrüche in dem Modulträger in den Bereichen der ersten und zweiten Kontaktfläche ermöglichen vorteilhaft die direkte Verbindung dieser Kontaktflächen mit dem jeweils zugeordneten Kontaktenden des Bauelementes zur berührungslosen Datenübertragung.

In einer bevorzugten Ausgestaltung der Erfindung verbindet das Leitmedium das erste Kontaktende stoffschlüssig mit der ersten Kontaktfläche und das zweite Kontaktende stoffschlüssig mit der zweiten Kontaktfläche. Besonders bevorzugt ist das Leitmedium ein Lot, Zinn oder ein aushärtbarer Leitkleber.

Dadurch werden die erste und die zweite Kontaktfläche stabil mit dem jeweils zugeordneten Kontaktende des Bauelementes zur berührungslosen Datenübertragung verbunden. Gegenüber aus dem Stand der Technik bekannten Verbindungen mittels einer Lötpaste oder einem Klebstoff reduziert dies die Anfälligkeit dieser Verbindungen gegen Beeinträchtigungen oder Unterbrechungen bei mechanischen Belastungen durch Verbiegungen der Chipkarte. Insbesondere wird dadurch die Zuverlässigkeit des elektrischen Kontaktes des Chipmoduls mit dem Bauelement zur berührungslosen Datenübertragung erhöht.

Die erste Kontaktfläche und die zweite Kontaktfläche sind bevorzugt in einem Kontaktfeld der Chipkarte außerhalb der in dem Standard ISO 7816-2 vorgesehenen Kontaktzonen C1, C2, C3, C5, C6, C7 angeordnet.

Dies ermöglicht vorteilhaft die Anordnung weiterer Kontaktflächen unter Berücksichtigung des Standards ISO 7816-2. Die Kompatibilität der Chipkarte mit diesem Standard erlaubt insbesondere die Verwendung der Chipkarte in Verbindung mit auf diesen Standard ausgelegten Lesegeräten.

Die erste Kontaktfläche und die zweite Kontaktfläche sind ferner vorzugsweise jeweils über Bonddraht, der durch jeweils einen weiteren Durchbruch in dem Modulträger geführt ist, mit jeweils einem elektrischen Anschluss des Chip elektrisch leitend verbunden. Im Falle, dass der jeweilige weitere Durchbruch nicht in der Nähe des entsprechenden elektrischen Anschlusses des Chip angeordnet ist, ist auf einer Unterseite des Modulträgers eine Metallstruktur aufgebracht, die ein Ende des durch den jeweiligen weiteren Durchbruch geführten Bonddrahtes mit einem ersten Ende eines weiteren Bonddrahtes verbindet, dessen zweites Ende mit dem jeweiligen elektrischen Anschluss des Chip verbunden ist.

Auf diese Weise werden die erste Kontaktfläche und die zweite Kontaktfläche jeweils durch Bondung mit einem elektrischen Anschluss des Chip verbunden. Die Bondung mittels der zusätzlichen Metallstruktur wird bevorzugt dann eingesetzt, wenn die weiteren Durchbrüche, durch die jeweils Bonddraht geführt wird, geometrisch ungünstig zu dem jeweiligen elektrischen Anschluss des Chip angeordnet sind. Die Metallstruktur ermöglicht somit vorteilhaft eine indirekte Bondung in Fällen, in denen eine direkte Bondung nicht oder nur unter unverhältnismäßig hohem Aufwand möglich ist.

Bei dem erfindungsgemäßen Verfahren zur Herstellung einer erfindungsgemäßen Chipkarte wird in einem ersten Verfahrensschritt der Kartenkörper mit dem Bauelement zur berührungslosen Datenübertragung erstellt. In einem zweiten Verfahrensschritt werden die Ausnehmung für das Chipmodul und jeweils eine Kontaktausnehmung zu dem ersten Kontaktende und dem zweiten Kontaktende des Bauelementes zur berührungslosen Datenübertragung in den Kartenkörper gearbeitet. In einem dritten Verfahrensschritt wird Leitmedium in Bereichen der Kontaktenden und/oder der ersten Kontaktfläche und/oder der zweiten Kontaktfläche aufgebracht. In einem vierten Verfahrensschritt wird wenigstens eine Klebfläche auf einer Unterseite des Chipmoduls mit einem Modulklebstoff beschichtet. In einem fünften Verfahrensschritt wird das Chipmodul in die Ausnehmung eingesetzt. In einem sechsten Verfahrensschritt wird das Chipmodul in der Ausnehmung befestigt. In einem siebten Verfahrensschritt werden mittels des Leitmediums das erste Kontaktende elektrisch leitend mit der ersten Kontaktfläche und das zweite Kontaktende elektrisch leitend mit der zweiten Kontaktfläche verbunden, wobei das Leitmedium erwärmt wird, indem der Chipkarte in den Bereichen der ersten Kontaktfläche und der zweiten Kontaktfläche lokal Energie zugeführt wird.

Dabei wird im siebten Schritt ausgenutzt, dass die erste Kontaktfläche und die zweite Kontaktfläche auf der Oberseite des Modulträgers angeordnet sind, so dass ihnen direkt lokal Energie zur Erwärmung des Leitmediums zugeführt werden kann. Dies hat den Vorteil, dass auf diese Weise gegenüber den aus dem Stand der Technik bekannten Verfahren das Leitmedium deutlich stärker erwärmt werden kann, ohne den üblicherweise aus einem Kunststoff gefertigten Kartenkörper der Chipkarte zu beschädigen oder zu zerstören. Insbesondere kann das Leitmedium auf eine zum Löten, Schweißen oder Leitkleben ausreichende Temperatur erwärmt werden.

Dementsprechend wird das Leitmedium im siebten Verfahrensschritt bevorzugt so stark erwärmt, dass das erste Kontaktende stoffschlüssig mit der ersten Kontaktfläche und das zweite Kontaktende stoffschlüssig mit der zweiten Kontaktfläche durch Löten, Schweißen oder Leitkleben verbunden werden.

Derartige Verbindungen der ersten Kontaktfläche und der zweiten Kontaktfläche mit dem jeweiligen zugeordneten Kontaktende haben die oben bereits genannten Vorteile, die Stabilität der Verbindungen bei mechanischen Beanspruchungen und damit die Zuverlässigkeit des elektrischen Kontaktes des Chipmoduls mit dem Bauelement zur berührungslosen Datenübertragung zu erhöhen.

In einer bevorzugten Ausgestaltung des Verfahrens wird das Leitmedium in dem dritten Verfahrensschritt in Form von Lotformteilen aufgebracht.

Die Verwendung von Lotformteilen hat den Vorteil, dass dadurch eine durch das Volumen der Lotformteile vorgebbare Menge des Leitmediums eingebracht wird. Ferner hat sie den Vorteil, dass die Form der Lotformteile optimal der Form und Größe der Kontaktausnehmungen im Kartenkörper sowie des ersten und des zweiten Durchbruchs in dem Modulträger angepasst werden kann.

Ferner wird das Leitmedium in dem dritten Verfahrensschritt vorzugsweise durch Energiezufuhr stoffschlüssig und elektrisch leitend mit den Kontaktenden verbunden.

Dadurch wird eine stoffschlüssige und elektrisch leitende Verbindung der Kontaktenden mit dem Leitmedium bereits vor dem Einsetzen des Chipmoduls in die Ausnehmung des Kartenkörpers hergestellt. Dies hat die Vorteile, dass dem Leitmedium vor Einsetzen des Chipmoduls einfacher Energie zugeführt werden kann als nach dem Einsetzen des Chipmoduls, und dass nach dem Einsetzen des Chipmoduls nur noch eine stoffschlüssige und elektrisch leitende Verbindung des Leitmediums mit der ersten und der zweiten Kontaktfläche hergestellt werden braucht.

Ferner kann auf diese Weise Leitmedium zunächst im dritten Verfahrensschritt durch punktuelle Energiezufuhr mit den Kontaktenden verbunden werden, wodurch es in seiner Lage vorteilhaft fixiert wird, so dass es in nachfolgenden Verfahrensschritten nicht aus dieser Lage gebracht wird, bevor es in dem siebten Verfahrensschritt endgültig mit der ersten und zweiten Kontaktfläche und den Kontaktenden verbunden wird.

Eine weitere Ausgestaltung des dritten Verfahrensschrittes sieht vor, dass Oberflächenbereiche der Kontaktenden vor dem Aufbringen des Leitmediums zur Verbesserung ihrer elektrischen Leitfähigkeit bearbeitet werden. Dazu werden sie bevorzugt aufgeraut, gefräst, sandgestrahlt, geprägt, plasmageätzt, ultraschallbehandelt oder metallisiert, oder es werden Erhebungen auf die Oberflächenbereiche aufgeschweißt oder elektrisch leitende Stoffe auf die Oberflächenbereiche aufgelötet.

Dadurch wird die elektrische Leitfähigkeit der Kontaktenden erhöht und damit die elektrische Verbindung des Chipmoduls mit dem Bauelement zur berührungslosen Datenübertragung vorteilhaft verbessert.

Vorzugsweise werden in dem vierten Verfahrensschritt der erste Durchbruch und der zweite Durchbruch in dem Modulträger jeweils wenigstens dreiseitig von dem Modulklebstoff umgeben.

Dadurch werden die Bereiche des Modulträgers, an denen Leitmedium angeordnet wird, stärker mit Klebstoffversehen als im Falle der aus dem Stand der Technik bekannten Chipkarten mit an der Unterseite des Modulträgers angeordneten Kontaktflächen, in deren Bereich kein Klebstoff angebracht werden darf. Dies erhöht die Festigkeit der Verbindung des Chipmoduls mit dem Kartenkörper gegenüber dem Stand der Technik und reduziert damit vorteilhaft die Gefahr einer ganz- oder teilflächigen Ablösung des Chipmoduls vom Kartenkörper bei mechanischen Belastungen durch Verbiegen der Chipkarte.

Eine bevorzugte Ausgestaltung des fünften Verfahrensschrittes sieht vor, dass die erste Kontaktfläche und/oder die zweite Kontaktfläche und/oder die Kontaktenden vor dem Einsetzen des Chipmoduls wenigstens teilflächig erwärmt werden.

Durch die Erwärmung wird die Befestigung des Chipmoduls in der Ausnehmung mittels des Modulklebstoffes erleichtert. Die Erwärmung vor dem Einsetzen des Chipmoduls ist vorteilhaft, da auf diese Weise der Kartenkörper zum Aufklebung des Chipmoduls weniger stark erwärmt wird als bei einer Erwärmung ausschließlich nach dem Einsetzen des Chipmoduls. Dies reduziert Verformungen und Beeinträchtigungen des Kartenkörpers durch dessen Erwärmung.

In dem sechsten Verfahrensschritt wird das Chipmodul bevorzugt zunächst punktuell mittels des Modulklebstoffes stoffschlüssig mit dem Kartenkörper verbunden.

Dadurch wird das Chipmodul zunächst in der Ausnehmung in dem Kartenkörper fixiert, so dass eine flächige Verbindung des Chipmoduls mit dem Kartenkörper vorteilhaft gleichzeitig mit dem siebten Verfahrensschritt erfolgen kann, in dem die erste Kontaktfläche und die zweite Kontaktfläche mit dem jeweiligen zugeordneten Kontaktende verbunden werden.

Dementsprechend werden der sechste und der siebte Verfahrensschritt vorzugsweise gleichzeitig durchgeführt, wobei das Chipmodul durch Erwärmung des Modulklebstoffes flächig stoffschlüssig in der Ausnehmung befestigt wird.

Dies vereinfacht vorteilhaft das Verfahren und verringert weiter die Belastung des Kartenkörpers durch Erwärmung im Herstellungsprozess, da die Erwärmung zur flächigen Befestigung des Chipmoduls am Kartenkörper und die Energiezufuhr zur Erwärmung des Leitmediums gleichzeitig erfolgen.

Weitere Vorteile, Merkmale und Einzelheiten der Erfindung werden im Folgenden anhand von Ausführungsbeispielen unter Bezugnahme auf Zeichnungen beschrieben.

Darin zeigen:
- Figur 1: eine Draufsicht auf eine Chipkarte mit einem Chipmodul, das ein Kontaktfeld zur elektrischen Kontaktierung aufweist,
- Figur 2: eine Draufsicht auf einen Kartenkörper einer Chipkarte mit einer Ausnehmung für ein Chipmodul und freigelegten Kontaktenden eines Bauelementes zur berührungslosen Datenübertragung,
- Figur 3: eine Draufsicht auf eine Unterseite eines Modulträgers eines Chipmoduls mit einem auf dem Modulträger angeordneten Chip und Bonddrähten,
- Figur 4: eine Draufsicht auf eine Unterseite eines Chipmoduls, und
- Figur 5: ausschnittsweise einen Längsschnitt durch eine Chipkarte im Bereich des Chipmoduls.

Einander entsprechende Teile sind in allen Figuren mit den gleichen Bezugszeichen versehen.

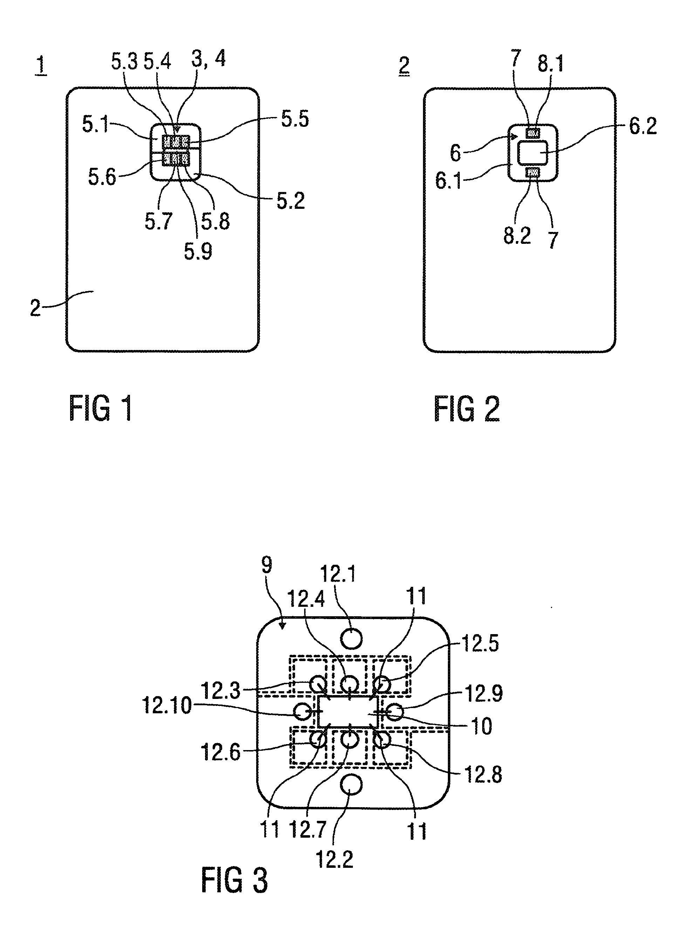

**Figur 1** zeigt schematisch eine Draufsicht auf eine Chipkarte 1 mit einem Kartenkörper 2 und einem Chipmodul 3, das ein Kontaktfeld 4 zur elektrischen Kontaktierung aufweist.

Der Kartenkörper 2 ist aus Kunststoff gefertigt. Innerhalb des Kartenkörpers 2 befindet sich ein beispielsweise als eine Antenne ausgebildetes Bauelement zur berührungslosen Datenübertragung zu und/oder von einem externen Lesegerät mittels elektromagnetischer Felder.

Das Kontaktfeld 4 weist in einem oberen Randbereich eine erste Kontaktfläche 5.1, in einem unteren Randbereich eine zweite Kontaktfläche 5.2, und in einem Mittelbereich sechs weitere Kontaktflächen 5.3 bis 5.8 auf. Die Lage der weiteren Kontaktflächen 5.3 bis 5.8 entspricht jeweils der Lage einer der in dem Standard ISO 7816-2 vorgesehenen Kontaktzonen C1, C2, C3, C5, C6, C7. Die erste Kontaktfläche 5.1 und die zweite Kontaktfläche 5.2 sind außerhalb dieser Kontaktzonen angeordnet.

Ein von den Kontaktflächen 5.1 bis 5.8 umgebener innerer Bereich 5.9 des Kontaktfeldes 4 ist in diesem Ausführungsbeispiel elektrisch isolierend ausgebildet, kann jedoch in anderen Ausführungsbeispielen ebenfalls als eine zusätzliche Kontaktfläche ausgebildet sein und beispielsweise mit einer einen Massekontakt bildenden Kontaktfläche 5.3 bis 5.8 verbunden sein.

Die Chipkarte 1 ist eine so genannte Dual-Interface-Chipkarte mit einer durch das Bauelement zur berührungslosen Datenübertragung verfügbaren Schnittstelle zum kontaktlosen Datenaustausch und durch die weiteren Kontaktflächen 5.3 bis 5.8 verfügbaren Schnittstellen zum kontaktbehafteten Datenaustausch.

**Figur 2** zeigt eine Draufsicht auf den Kartenkörper 2 der in Figur 1 dargestellten Chipkarte 1. Der Kartenkörper 2 weist eine Ausnehmung 6 zur Aufnahme des Chipmoduls 3 auf, und jeweils eine Kontaktausnehmung 7 zu einem ersten Kontaktende 8.1 und einem zweiten Kontaktende 8.2 des Bauelementes zur berührungslosen Datenübertragung auf.

Dabei sind die Kontaktenden 8.1, 8.2 elektrische Anschlüsse des Bauelementes zur berührungslosen Datenübertragung zu dessen elektrischer Kontaktierung. Die Kontaktausnehmungen 7 sind Öffnungen in dem Kartenkörper 2 zu den Kontaktenden 8.1, 8.2, um diese zu deren elektrischer Kontaktierung freizulegen.

Die Ausnehmung 6 korrespondiert in ihren Abmessungen und ihrem Profil zu den Abmessungen und dem Profil des Chipmoduls 3, so dass dieses passgenau in die Ausnehmung eingesetzt werden kann.

**Figur 3** zeigt eine Draufsicht auf eine Unterseite eines Modulträgers 9 des Chipmoduls 3 mit einem auf dem Modulträger 9 angeordneten Chip 10 und Bonddrähten 11 zur elektrischen Verbindung der Kontaktflächen 5.1 bis 5.8 mit dem Chip 10.

Der Modulträger 9 ist Träger der Kontaktflächen 5.1 bis 5.8 und des Chipmoduls 3. Dabei sind die Kontaktflächen 5.1 bis 5.8 auf der Oberseite des Modulträgers 9 angeordnet, so dass sie Oberflächenbereiche der Chipkarte 1 bilden, während der Chip 10 auf der in die Ausnehmung 6 gerichtete Unterseite des Modulträgers 9 angeordnet ist.

Der Modulträger 9 weist einen ersten Durchbruch 12.1 im Bereich der ersten Kontaktfläche 5.1, einen zweiten Durchbruch 12.2 im Bereich der zweiten Kontaktfläche 5.2 sowie jeweils einen weiteren Durchbruch 12.3 bis 12.10 im Bereich jeder Kontaktfläche 5.1 bis 5.8 auf.

Die Bonddrähte 11 sind jeweils von einer Kontaktfläche 5.1 bis 5.8 durch einen korrespondierenden weiteren Durchbruch 12.3 bis 12.10 zu dem Chip 10 geführt und verbinden die jeweilige Kontaktfläche 5.1 bis 5.8 direkt mit einem elektrischen Anschluss des Chips 10. Wenn eine derartige direkte Bondung aufgrund geometrisch ungünstiger Lagen von elektrischen Anschlüssen des Chip 10 nicht für alle Kontaktflächen 5.1 bis 5.8 möglich ist, wird zusätzlich jeweils eine nicht dargestellte Metallstruktur zur oben bereits beschriebenen indirekten Bondung einer Kontaktfläche 5.1 bis 5.8 und des entsprechenden elektrischen Anschlusses des Chip 10 auf die Unterseite des Modulträgers 9 aufgebracht.

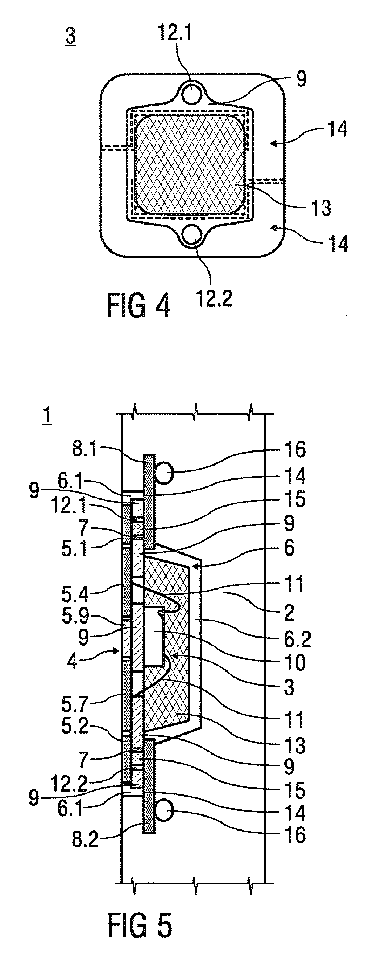

**Figur 4** zeigt eine Draufsicht auf eine Unterseite des Chipmoduls 3 vor dessen Einsetzen in die Ausnehmung 6 des Kartenkörpers 2. Im Mittelbereich des Modulträgers 9 ist über dem Chip 10 eine Chipabdeckung 13 aus einer Vergussmasse aufgebracht, die den Chip 10 kappenartig bedeckt und schützt.

Auf eine Klebfläche 14, die sich über die Randbereiche der Unterseite des Modulträgers 9 erstreckt, ist ein Modulklebstoff aufgetragen, mittels dessen das Chipmodul 3 nach dem Einsetzen in die Ausnehmung 6 stoffschlüssig mit dem Kartenkörper 2 verbunden wird, um es in der Ausnehmung 6 zu befestigen.

**Figur 5** zeigt die in Figur 1 dargestellte Chipkarte 1 in einem Längsschnitt entlang einer Schnittgerade durch den ersten Durchbruch 12.1 und den zweiten Durchbruch 12.2. Darin ist insbesondere zu erkennen, dass die Ausnehmung 6 im Kartenkörper 2 einen äußeren Ausnehmungsbereich 6.1 und einen inneren Ausnehmungsbereich 6.2 aufweist, wobei der innere Ausnehmungsbereich 6.2 eine tiefere Ausnehmung im Kartenkörper 2 darstellt als der äußere Ausnehmungsbereich 6.1 und in seiner Größe, Form und Größe zu der Chipabdeckung 13 korrespondiert, die er aufnimmt.

Die erste Kontaktfläche 5.1 ist mit dem ersten Kontaktende 8.1 durch ein als ein Lot ausgebildetes und durch den ersten Durchbruch 12.1 im Modulträger 9 geführtes Leitmedium 15 stoffschlüssig und elektrisch leitend verbunden. Entsprechend ist die zweite Kontaktfläche 5.2 mit dem zweiten Kontaktende 8.2 durch den zweiten Durchbruch 12.2 im Modulträger 9 über das Leitmedium 15 stoffschlüssig und elektrisch leitend verbunden.

Dargestellt ist ferner schematisch ein Antennendraht 16 des Bauelementes zur berührungslosen Datenübertragung, der mit den Kontaktenden 8.1, 8.2 elektrisch leitend verbunden ist und innerhalb des Kartenkörpers 2 verlegt ist.

Zur Herstellung der Chipkarte 1 wird in einem ersten Verfahrensschritt der Kartenkörper 2 mit dem Bauelement zur berührungslosen Datenübertragung erstellt.

In einem zweiten Verfahrensschritt werden die Ausnehmung 6 für das Chipmodul und die Kontaktausnehmungen 7 zu dem ersten Kontaktende 8.1 und dem zweiten Kontaktende 8.2 des Bauelementes zur berührungslosen Datenübertragung in den Kartenkörper 2 gefräst.

In einem dritten Verfahrensschritt wird das Leitmedium 15 in Bereichen der Kontaktenden 8.1 und 8.2 in Form von Lotformteilen, die über den Kontaktausnehmungen 7 positioniert werden, aufgebracht und durch Energiezufuhr erhitzt, wodurch es stoffschlüssig und elektrisch leitend mit den Kontaktenden 8.1, 8.2 verbunden wird. Dabei erfolgt die Energiezufuhr beispielsweise durch Erwärmung, Ultraschall, Wirbelströme und/oder Lichtenergie.

Optional werden Oberflächenbereiche der Kontaktenden 8.1, 8.2 vor dem Aufbringen des Leitmediums 15 zur Verbesserung ihrer elektrischen Leitfähigkeit aufgeraut, gefräst, sandgestrahlt, geprägt, plasmageätzt, ultraschallbehandelt oder metallisiert, oder es werden Erhebungen auf die Oberflächenbereiche aufgeschweißt oder elektrisch leitende Stoffe auf die Oberflächenbereiche aufgelötet.

In einem vierten Verfahrensschritt wird die Klebfläche 14 mit dem Modulklebstoff beschichtet.

In einem fünften Verfahrensschritt werden die erste Kontaktfläche 5.1 und die zweite Kontaktfläche 5.2 zunächst erwärmt und danach wird das Chipmodul 3 in die Ausnehmung 6 eingesetzt.

In einem sechsten und siebten Verfahrensschritt wird das Chipmodul 3 zunächst punktuell in der Ausnehmung befestigt, indem der auf die Klebfläche 14 aufgebrachte Modulklebstoff lokal erwärmt wird. Danach werden der Klebfläche 14 und der ersten Kontaktfläche 5.1 und der zweiten Kontaktfläche 5.2 Energie zugeführt, beispielsweise durch Erwärmung, Ultraschall, Wirbelströme und/oder Lichtenergie, um das Chipmodul 3 im Bereich der Klebfläche 14 mit dem Kartenkörper 2, die erste Kontaktfläche 5.1 über das Leitmedium 15 mit dem ersten Kontaktende 8.1 und die zweite Kontaktfläche 5.2 über das Leitmedium 15 mit dem zweiten Kontaktende 8.2 stoffschlüssig zu verbinden.

Dabei wird dem Leitmedium 15 über die erste Kontaktfläche 5.1 und die zweite Kontaktfläche 5.2 jeweils lokal soviel Energie zugeführt, dass die erste Kontaktfläche 5.1 mit dem ersten Kontaktende 8.1 und die zweite Kontaktfläche 5.2 mit dem zweiten Kontaktende 8.2 verlötet werden.

### BEZUGSZEICHENLISTE

- 1: Chipkarte
- 2: Kartenkörper
- 3: Chipmodul
- 4: Kontaktfeld
- 5.1: erste Kontaktfläche
- 5.2: zweite Kontaktfläche
- 5.3 bis 5.8: weitere Kontaktflächen
- 5.9: innerer Bereich
- 6: Ausnehmung
- 6.1: äußerer Ausnehmungsbereich
- 6.2: innerer Ausnehmungsbereich
- 7: Kontaktausnehmung
- 8.1: erstes Kontaktende
- 8.2: zweites Kontaktende
- 9: Modulträger
- 10: Chip
- 11: Bonddraht
- 12.1: erster Durchbruch
- 12.2: zweiter Durchbruch
- 12.3 bis 12.10: weitere Durchbrüche
- 13: Chipabdeckung
- 14: Klebfläche
- 15: Leitmedium
- 16: Antennendraht

## Patentansprüche

1. Chipkarte (1) mit einem Kartenkörper (2), einem Chipmodul (3) und einem Bauelement zur berührungslosen Datenübertragung, wobei das Chipmodul (3) in einer Ausnehmung (6) in dem Kartenkörper (2) befestigt ist und einen Modulträger (9) mit Kontaktflächen (5.1 bis 5.8), bestehend aus einer ersten Kontaktfläche (5.1), einer zweiten Kontaktfläche (5.2) und weiterer Kontaktflächen (5.3 bis 5.8), zur elektrischen Kontaktierung und einen auf dem Modulträger (9) angeordneten Chip (10) aufweist, und wobei das Bauelement zur berührungslosen Datenübertragung in dem Kartenkörper (2) angeordnet ist und zwei Kontaktenden (8.1, 8.2) aufweist, von denen ein erstes Kontaktende (8.1) der ersten Kontaktfläche (5.1) des Chipmoduls (3) zugeordnet und mit dieser mittels eines Leitmediums (15) elektrisch leitend verbunden ist und das zweite Kontaktende (8.2) der zweiten Kontaktfläche (5.2) des Chipmoduls (3) zugeordnet und mit dieser mittels des Leitmediums (15) elektrisch leitend verbunden ist, wobei die erste Kontaktfläche (5.1) und die zweite Kontaktfläche (5.2) auf einer Oberseite des Modulträgers (9) angeordnet sind, so dass sie Oberflächenbereiche der Chipkarte (1) bilden, und wobei der Modulträger (9) im Bereich der ersten Kontaktfläche (5.1) einen ersten Durchbruch (12.1) für das Leitmedium (15) und im Bereich der zweiten Kontaktfläche (5.2) einen zweiten Durchbruch (12.2) für das Leitmedium (15) aufweist,
**dadurch gekennzeichnet, dass**
- die erste Kontaktfläche (5.1) und die zweite Kontaktfläche (5.2) außerhalb der in dem Standard ISO 7816-2 vorgesehenen Kontaktzonen C1, C2, C3, C5, C6, C7 angeordnet sind und die Lage der weiteren Kontaktflächen (5.3 bis 5.8) jeweils der Lage einer der in dem Standard ISO 7816-2 vorgesehenen Kontaktzonen C1, C2, C3, C5, C6, C7 entspricht, und
- die erste Kontaktfläche (5.1) und/oder die zweite Kontaktfläche (5.2) über Bonddraht (11), der durch jeweils einen weiteren Durchbruch (12.9, 12.10) in dem Modulträger (9) geführt ist, mit einer auf einer Unterseite des Modulträgers (9) aufgebrachten Metallstruktur verbunden ist, wobei die Metallstruktur ein Ende des durch den weiteren Durchbruch (12.9, 12.10) geführten Bonddrahtes (11) mit einem ersten Ende eines weiteren Bonddrahtes (11) verbindet, dessen zweites Ende mit einem elektrischen Anschluss des Chip (10) verbunden ist..

2. Chipkarte (1) nach Anspruch 1, **dadurch gekennzeichnet, dass** das Leitmedium (15) das erste Kontaktende (8.1) stoffschlüssig mit der ersten Kontaktfläche (5.1) und das zweite Kontaktende (8.2) stoffschlüssig mit der zweiten Kontaktfläche (5.2) verbindet.

3. Verfahren zur Herstellung einer Chipkarte (1) gemäß einem der Ansprüche 1 oder 2, bei dem in einem ersten Verfahrensschritt der Kartenkörper (2) mit dem Bauelement zur berührungslosen Datenübertragung erstellt wird, in einem zweiten Verfahrensschritt die Ausnehmung (6) für das Chipmodul (3) und jeweils eine Kontaktausnehmung (7) zu dem ersten Kontaktende (8.1) und dem zweiten Kontaktende (8.2) des Bauelementes zur berührungslosen Datenübertragung in den Kartenkörper (2) gearbeitet werden, in einem dritten Verfahrensschritt Leitmedium (15) in Bereichen der Kontaktenden (8.1, 8.2) und/oder der ersten Kontaktfläche (5.1) und/oder der zweiten Kontaktfläche (5.2) aufgebracht wird, in einem vierten Verfahrensschritt wenigstens eine Klebfläche (14) auf einer Unterseite des Chipmoduls (3) mit einem Modulklebstoff beschichtet wird, in einem fünften Verfahrensschritt das Chipmodul (3) in die Ausnehmung (6) eingesetzt wird, in einem sechsten Verfahrensschritt das Chipmodul (3) in der Ausnehmung (6) befestigt wird, und in einem siebten Verfahrensschritt mittels des Leitmediums (15) das erste Kontaktende (8.1) elektrisch leitend mit der ersten Kontaktfläche (5.1) und das zweite Kontaktende (8.2) elektrisch leitend mit der zweiten Kontaktfläche (5.2) verbunden werden, **dadurch gekennzeichnet, dass**
- die erste Kontaktfläche (5.1) und die zweite Kontaktfläche (5.2) außerhalb der in dem Standard ISO 7816-2 vorgesehenen Kontaktzonen C1, C2, C3, C5, C6, C7 und die weiteren Kontaktflächen (5.3 bis 5.8) jeweils in einer der in dem Standard ISO 7816-2 vorgesehenen Kontaktzonen C1, C2, C3, C5, C6, C7 angeordnet werden,
- auf einer Unterseite des Modulträgers (9) eine Metallstruktur aufgebracht wird,
- die erste Kontaktfläche (5.1) und/oder die zweite Kontaktfläche (5.2) über einen Bonddraht (11), der durch einen weiteren Durchbruch (12.9, 12.10) in dem Modulträger (9) geführt wird, die Metallstruktur und einen weiteren Bonddraht (11) mit einem elektrischen Anschluss des Chip (10) verbunden wird, wobei ein Ende des durch den weiteren Durchbruch (12.9, 12.10) geführten Bonddrahtes und ein erstes Ende des weiteren Bonddrahtes (11) mit der Metallstruktur verbunden werden und das zweite Ende des weiteren Bonddrahtes (11) mit dem elektrischen Anschluss des Chip (10) verbunden wird, und
- das Leitmedium (15) in dem siebten Verfahrensschritt erwärmt wird, indem der Chipkarte (1) in den Bereichen der ersten Kontaktfläche (5.1) und der zweiten Kontaktfläche (5.2) lokal Energie zugeführt wird.

4. Verfahren nach Anspruch 3, **dadurch gekennzeichnet, dass** bei der Erwärmung des Leitmediums (15) im siebten Verfahrensschritt das erste Kontaktende (8.1) stoffschlüssig mit der ersten Kontaktfläche (5.1) und das zweite Kontaktende (8.2) stoffschlüssig mit der zweiten Kontaktfläche (5.2) durch Löten, Schweißen oder Leitkleben verbunden werden.

5. Verfahren nach Anspruch 3 oder 4, **dadurch gekennzeichnet, dass** in dem dritten Verfahrensschritt das Leitmedium (15) in Form von Lotformteilen aufgebracht wird.

6. Verfahren nach einem der Ansprüche 3 bis 5, **dadurch gekennzeichnet, dass** das Leitmedium (15) in dem dritten Verfahrensschritt durch Energiezufuhr stoffschlüssig und elektrisch leitend mit den Kontaktenden (8.1, 8.2) und/oder der ersten Kontaktfläche (5.1) und/oder der zweiten Kontaktfläche (5.2) verbunden wird.

7. Verfahren nach Anspruch 6, **dadurch gekennzeichnet, dass** die Energiezufuhr durch Erwärmung, Ultraschall, Wirbelströme und/oder Lichtenergie erfolgt.

8. Verfahren nach einem der Ansprüche 3 bis 7, **dadurch gekennzeichnet, dass** Oberflächenbereiche der Kontaktenden (8.1, 8.2) in dem dritten Verfahrensschritt vor dem Aufbringen des Leitmediums (15) zur Verbesserung ihrer elektrischen Leitfähigkeit bearbeitet werden.

9. Verfahren nach Anspruch 8, **dadurch gekennzeichnet, dass** die Oberflächenbereiche der Kontaktenden (8.1, 8.2) aufgeraut, gefräst, sandgestrahlt, geprägt, plasmageätzt, ultraschallbehandelt oder metallisiert werden oder Erhebungen auf die Oberflächenbereiche aufgeschweißt oder elektrisch leitende Stoffe auf die Oberflächenbereiche aufgelötet werden.

10. Verfahren nach einem der Ansprüche 3 bis 9, **dadurch gekennzeichnet, dass** in dem vierten Verfahrensschritt der erste Durchbruch (12.1) und der zweite Durchbruch (12.2) in dem Modulträger (9) jeweils wenigstens dreiseitig von dem Modulklebstoff umgeben werden.

11. Verfahren nach einem der Ansprüche 3 bis 10, **dadurch gekennzeichnet, dass** die erste Kontaktfläche (5.1) und/oder die zweite Kontaktfläche (5.2) und/oder die Kontaktenden (8.1, 8.2) in dem fünften Verfahrensschritt vor dem Einsetzen des Chipmoduls (3) wenigstens teilflächig erwärmt werden.

12. Verfahren nach einem der Ansprüche 3 bis 11, **dadurch gekennzeichnet, dass** das Chipmodul (3) in dem sechsten Verfahrensschritt zunächst punktuell mittels des Modulklebstoffes stoffschlüssig mit dem Kartenkörper (2) verbunden wird.

13. Verfahren nach einem der Ansprüche 3 bis 12, **dadurch gekennzeichnet, dass** der sechste und der siebte Verfahrensschritt gleichzeitig durchgeführt werden und dabei das Chipmodul (3) durch Erwärmung des Modulklebstoffes flächig stoffschlüssig in der Ausnehmung (6) befestigt wird.

## Claims

1. Chip card (1) with a card body (2), a chip module (3) and a circuit element for non-contacting data transmission, while the chip module (3) is fastened in a recess (6) in the card body (2) and presents a module carrier (9) with contact surfaces (5.1 to 5.8), consisting of a first contact surface (5.1), a second contact surface (5.2) and further contact surfaces (5.3 to 5.8), for electrical contacting and a chip (10) arranged on the module carrier (9), and while the circuit element for non-contacting data transmission is arranged in the card body (2) and presents two contact terminals (8.1, 8.2), from which a first contact terminal (8.1) is assigned to the first contact surface (5.1) of the chip module (3) and connected electrically to the latter by means of a conducting medium (15) and the second contact terminal (8.2) is assigned to the second contact surface (5.2) of the chip module (3) and connected electrically to that second contact surface (5.2) by means of a conducting medium (15), while the first contact surface (5.1) and the second contact surface (5.2) are arranged on a top face of the module carrier (9), such that they form surface areas of the chip card (1), and while the module carrier (9) presents a first aperture (12.1) for the conducting medium (15) in the area of the first contact surface (5.1) and a second aperture (12.2) for the conducting medium (15) in the area of the second contact surface (5.2),
**characterized in that**
- the first contact surface (5.1) and the second contact surface (5.2) are located outside the contact zones C1, C2, C3, C5, C6, C7 provided for in the ISO 7816-2 standard and the location of the further contact surfaces (5.3 to 5.8) each corresponds to the location of one of the contact zones C1, C2, C3, C5, C6, C7 provided for in the ISO 7816-2 standard, and
- the first contact surface (5.1) and/or the second contact surface (5.2) are connected, via bonding wire (11), which is routed each through a further aperture (12.9, 12.10) in the module carrier (9), to a metal structure applied to a lower side of the module carrier (9), while the metal structure connects one end of the bonding wire (11) routed through the further aperture (12.9, 12.10) with a first end of a further bonding wire (11), the second end of which is connected with an electrical connection of the chip (10).

2. Chip card (1) as claimed in claim 1, **characterized in that** the conducting medium (15) establishes a material-formed connection from the first contact terminal (8.1) to the first contact surface (5.1) and from the second contact terminal (8.2) to the second contact surface (5.2).

3. Procedure for manufacturing a chip card (1) as claimed in any one of the claims 1 or 2, in which the card body (2) is established with the circuit element for non-contacting data transmission in a first processing step, the recess (6) for the chip module (3) and one contact recess (7) each to the first contact terminal (8.1) and to the second contact terminal (8.2) of the circuit element for non-contacting data transmission are recessed in the card body (2) in a second processing step, conducting medium (15) is applied in the area of the contact terminals (8.1, 8.2) and/or the first contact surface (5.1) and/or the second contact surface (5.2) in a third processing step, at least one adherent (14) is coated with a module adhesive on a lower side of the chip module (3) in a fourth processing step, the chip module (3) is inserted into the recess (6) in a fifth processing step, the chip module (3) is fastened in the recess (6) in a sixth processing step, and, in a seventh processing step, and using conducting medium (15), the first contact terminal (8.1) is electrically connected to the first contact surface (5.1) and the second contact terminal (8.2) is electrically connected to the second contact surface (5.2), **characterized in that**
- the first contact surface (5.1) and the second contact surface (5.2) are each arranged outside the contact zones C1, C2, C3, C5, C6, C7 provided for in the ISO 7816-2 standard and the further contact surfaces (5.3 to 5.8) are each arranged in one of the contact zones C1, C2, C3, C5, C6, C7 provided for in the ISO 7816-2 standard,
- a metal structure is applied to a lower side of the module carrier (9),
- the first contact surface (5.1) and/or the second contact surface (5.2), via a bonding wire (11), which is routed through a further aperture (12.9, 12.10) in the module carrier (9), the metal structure and a further bonding wire (11) are connected with an electrical connection of the chip (10), while one end of the bonding wire routed through a further aperture (12.9, 12.10) and a first end of the further bonding wire (11) are connected with the metal structure and the second end of the further bonding wire (11) is connected with the electrical connection of the chip (10), and
- in the seventh processing step, the conducting medium (15) is heated by locally supplying energy to the chip card (1) in the areas of the first contact surface (5.1) and of the second contact surface (5.2).

4. Procedure as claimed in claim 3, **characterized in that**, when heating the conducting medium (15) in the seventh processing step, a material-formed connection of the first contact terminal (8.1) is established with the first contact surface (5.1) and a material-formed connection of the second contact terminal (8.2) is established with the second contact surface (5.2) by soldering, welding or conductive adhesion.

5. Procedure as claimed in claim 3 or 4, **characterized in that**, in the third processing step, the conducting medium (15) is applied in the form of preformed parts made of solder or braze metal.

6. Procedure as claimed in any claim 3 through 5, **characterized in that** the conducting medium (15), in the third processing step and by means of energy input, is connected by a material-formed and electrically conductive connection with the contact terminals (8.1, 8.2) and/or the first contact surface (5.1) and/or the second contact surface (5.2).

7. Procedure as claimed in claim 6, **characterized in that** the energy input is achieved by heating, ultrasound, eddy currents and/or light energy.

8. Procedure as claimed in any claim 3 through 7, **characterized in that**, in the third processing step, surface areas of the contact terminals (8.1, 8.2) are machined for enhancing their electrical conductivity prior to the application of the conducting medium (15).

9. Procedure as claimed in claim 8, **characterized in that** the surface areas of the contact terminals (8.1, 8.2) are roughened, milled, sandblasted, embossed, plasma-etched, treated by ultrasound or metallized, or bumps are welded onto the surface areas or electrically conductive substances are soldered or brazed onto the surface areas.

10. Procedure as claimed in any claim 3 through 9, **characterized in that**, in the fourth processing step, the first aperture (12.1) and the second aperture (12.2) in the module carrier (9) are surrounded by the module adhesive at least on three sides each.

11. Procedure as claimed in any claim 3 through 10, **characterized in that** the first contact surface (5.1) and/or the second contact surface (5.2) and/or the contact terminals (8.1, 8.2) are heated at least on a part of their surfaces in the fifth processing step before inserting the chip module (3).

12. Procedure as claimed in any claim 3 through 11, **characterized in that** the chip module (3) is connected by a material-formed connection to the card body (2) established initially by selective spots using the module adhesive in the sixth processing step.

13. Procedure as claimed in any claim 3 through 12, **characterized in that** the sixth and the seventh processing steps are carried out at the same time and while the chip module (3) is fastened by establishing a two-dimensional material-formed connection in the recess (6) by heating the module adhesive.

## Revendications

1. Carte à puce (1) avec un corps de carte (2), un module de puce (3) et un composant pour la transmission de données sans contact, le module de puce (3) étant fixé dans un évidement (6) du corps de carte (2) et comportant un support de module (9) avec des surfaces de contact (5.1 à 5.8), composées d'une première surface de contact (5.1) et d'une deuxième surface de contact (5.2) et d'autres surfaces de contact (5.3 à 5.8) pour la mise en contact électrique, et une puce (10) disposée sur le support de module (9), le composant pour la transmission de données sans contact étant disposé dans le corps de carte (2) et comportant deux extrémités de contact (8.1, 8.2), dont une première extrémité de contact (8.1) correspond à la première surface de contact (5.1) du module de puce (3) et est reliée à celle-ci de manière électriquement conductrice par un support conducteur (15), et dont la deuxième extrémité de contact (8.2) correspond à la deuxième surface de contact (5.2) du module de puce (3) et est reliée à celle-ci de manière électriquement conductrice par le support conducteur (15), la première surface de contact (5.1) et la deuxième surface de contact (5.2) étant disposées sur une face supérieure du support de module (9), de manière à former des zones de surfaces de la carte à puce (1), et le support de module (9) comportant au niveau de la première surface de contact (5.1) un premier trou de perçage (12.1) pour le support conducteur (15), et au niveau de la deuxième surface de contact (5.2) un deuxième trou de perçage (12.2) pour le support conducteur (15),
**caractérisée**
- **en ce que** la première surface de contact (5.1) et la deuxième surface de contact (5.2) sont disposées en dehors des zones de contact C1, C2, C3, C5, C6, C7 prévues par la norme ISO 7816-2, et la position de chacune des autres surfaces de contact (5.3 à 5.8) correspond à celle d'une des zones de contact C1, C2, C3, C5, C6, C7 prévues par la norme ISO 7816-2, et
- **en ce que** la première surface de contact (5.1) et/ou la deuxième surface de contact (5.2) sont respectivement reliées de manière électriquement conductrice à une structure métallique appliquée sur une face inférieure du support de module (9), par un fil de liaison (11) passant par un autre trou de perçage (12.9, 12.10) dans le support de module (9), la structure métallique reliant une extrémité du fil de liaison (11) passé dans l'autre trou de perçage (12.9, 12.10) à une première extrémité d'un autre fil de liaison (11) dont la deuxième extrémité est reliée à une connexion électrique de la puce (10).

2. Carte à puce (1) selon la revendication 1, **caractérisée en ce que** le support conducteur (15) relie la première extrémité de contact (8.1) à la première surface de contact (5.1) par raccord de matière, et la deuxième extrémité de contact (8.2) à la deuxième surface de contact (5.2) par raccord de matière.

3. Procédé de fabrication d'une carte à puce (1) selon la revendication 1 ou la revendication 2, où le corps de carte (2) est fabriqué avec le composant pour la transmission de données sans contact lors d'une première étape de procédé, l'évidement (6) pour le module de puce (3) et un évidement de contact (7) respectivement pour la première extrémité de contact (8.1) et pour la deuxième extrémité de contact (8.2) du composant pour la transmission de données sans contact étant ménagés dans le corps de carte (2) lors d'une deuxième étape de procédé, le support conducteur (15) étant appliqué au niveau des extrémités de contact (8.1, 8.2) et/ou de la première surface de contact (5.1) et/ou de la deuxième surface de contact (5.2) lors d'une troisième étape de procédé, au moins une surface de collage (14) étant revêtue d'une colle modulaire sur une face inférieure du module de puce (3) lors d'une quatrième étape de procédé, le module de puce (3) étant mis en place dans l'évidement (6) lors d'une cinquième étape de procédé, le module de puce (3) étant fixé dans l'évidement (6) lors d'une sixième étape de procédé, et la première extrémité de contact (8.1) étant reliée de manière électriquement conductrice à la première surface de contact (5.1) et la deuxième extrémité de contact (8.2) étant reliée de manière électriquement conductrice à la deuxième surface de contact (5.2) au moyen du support conducteur (15) lors d'une septième étape de procédé, **caractérisé**
- **en ce que** la première surface de contact (5.1) et la deuxième surface de contact (5.2) sont disposées en dehors des zones de contact C1, C2, C3, C5, C6, C7 prévues par la norme ISO 7816-2, et la position de chacune des autres surfaces de contact (5.3 à 5.8) correspond à celle d'une des zones de contact C1, C2, C3, C5, C6, C7 prévues par la norme ISO 7816-2,
- **en ce qu'**une structure métallique est appliquée sur une face inférieure du support de module (9),
- **en ce que** la première surface de contact (5.1) et/ou la deuxième surface de contact (5.2) sont reliées par un fil de liaison (11) passant par un autre trou de perçage (12.9, 12.10) dans le support de module (9), la structure métallique est reliée par un autre fil de liaison (11) à une connexion électrique de la puce (10), une extrémité du fil de liaison (11) passé dans l'autre trou de perçage (12.9, 12.10) et une première extrémité d'un autre fil de liaison (11) étant reliées à la structure métallique, et la deuxième extrémité de l'autre fil de liaison (11) étant reliée à la connexion électrique de la puce (10), et
- **en ce que** le support conducteur (15) est chauffé lors de la septième étape de procédé, par apport local d'énergie à la carte à puce (1) au niveau de la première surface de contact (5.1) et de la deuxième surface de contact (5.2).

4. Procédé selon la revendication 3, **caractérisé en ce que**, pendant le chauffage du support conducteur (15) lors de la septième étape de procédé, la première extrémité de contact (8.1) est reliée à la première surface de contact (5.1) par raccord de matière, et la deuxième extrémité de contact (8.2) à la deuxième surface de contact (5.2) par raccord de matière, par brasage, soudage ou collage conducteur.

5. Procédé selon la revendication 3 ou la revendication 4, **caractérisé en ce que**, lors de la troisième étape de procédé, le support conducteur (15) est appliqué sous forme de métal d'apport préformé.

6. Procédé selon l'une des revendications 3 à 5, **caractérisé en ce que** le support conducteur (15) est relié aux extrémités de contact (8.1, 8.2) et/ou à la première surface de contact (5.1) et/ou à la deuxième surface de contact (5.2) par apport d'énergie avec raccord de matière et de manière électriquement conductrice lors de la troisième étape de procédé.

7. Procédé selon la revendication 6, **caractérisé en ce que** l'amenée d'énergie est réalisée par chauffage, ultrasons, courants de Foucault et/ou énergie lumineuse.

8. Procédé selon l'une des revendications 3 à 7, **caractérisé en ce que** des zones de surface des extrémités de contact (8.1, 8.2) sont usinées pour améliorer leur conductivité électrique avant l'application du support conducteur (15), lors de la troisième étape de procédé.

9. Procédé selon la revendication 8, **caractérisé en ce que** les zones de surface des extrémités de contact (8.1, 8.2) sont rugosifiées, fraisées, sablées, estampées, gravées au plasma, traitées aux ultrasons ou métallisées, ou **en ce que** des reliefs sont soudés sur les zones de surface, ou **en ce que** des matières électriquement conductrices sont brasées sur les zones de surface.

10. Procédé selon l'une des revendications 3 à 9, **caractérisé en ce que**, lors de la quatrième étape de procédé, le premier trou de perçage (12.1) et le deuxième trou de perçage (12.2) sont entourés par la colle modulaire sur au moins trois côtés dans le support de module (9).

11. Procédé selon l'une des revendications 3 à 10, **caractérisé en ce que** la première surface de contact (5.1) et/ou la deuxième surface de contact (5.2) et/ou les extrémités de contact (8.1, 8.2) sont chauffées au moins partiellement avant la mise en place du module de puce (3), lors de la cinquième étape de procédé.

12. Procédé selon l'une des revendications 3 à 11, **caractérisé en ce que** le module de puce (3) est d'abord ponctuellement relié au corps de carte (2) au moyen de la colle modulaire lors de la sixième étape de procédé.

13. Procédé selon l'une des revendications 3 à 12, **caractérisé en ce que** la sixième et la septième étapes de procédé sont exécutées simultanément, et **en ce que** le module de puce (3) est alors fixé à plat dans l'évidement (6) avec raccord de matière par chauffage de la colle modulaire.
